(19) **Europäisches Patentamt**
**European Patent Office**
**Office européen des brevets**

(11) **EP 4 766 050 A1**

(12) **EUROPEAN PATENT APPLICATION**

(43) Date of publication:
**24.06.2026 Bulletin 2026/26**

(51) International Patent Classification (IPC):
***H05K 7/20*** (2006.01)

(21) Application number: **24307252.7**

(52) Cooperative Patent Classification (CPC):
**H05K 7/20836**

(22) Date of filing: **20.12.2024**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **OVH**
**59100 Roubaix (FR)**

(72) Inventors:
- **CHEHADE, Ali**
  **59283 Moncheaux (FR)**
- **HNAYNO, Mohamad**
  **59110 La Madeleine (FR)**

(74) Representative: **BCF Global**
**17-21, rue Saint-Fiacre**
**75002 Paris (FR)**

Remarks:
Amended claims in accordance with Rule 137(2)
EPC.

(54) **DYNAMIC PRESSURE-BASED CONTROL SYSTEM OF A DATACENTER FLUID COOLING ARRANGEMENT**

(57) The disclosed embodiments are provide a liquid cooling arrangement and method for a server rack including input and output temperature sensors of the server rack, a liquid cooling subsystem comprising a pump unit to forcibly urge the cooling liquid flow, a liquid distribution circuit fluidly-coupled to the liquid cooling subsystem and the server rack and configured to convey the cooling liquid to/from the server rack, input and output pressure sensors configured to measure the pressure of the cooling liquid flow received, and issued, by the pump unit, and a control unit. The control unit is configured to direct the pump unit to operate at full capacity, quantify pressure differences between the input/output pressure sensor measurements, determine an optimal volume flow rate based on a desired predetermined temperature difference between the input/output temperatures and empirical pump operational characteristics, and adjust the pump unit speed based on the determined optimal flow rate.

FIG. 1A

## Description

### FIELD

The present technology generally relates to the field of datacenter cooling measures and, in particular, to the pressure control of datacenter liquid cooling arrangements.

### BACKGROUND

Datacenters as well as many computer processing facilities house multitudes rack-mounted electronic processing equipment. In operation, such electronic processing equipment generates a substantial amount of heat that must be dissipated to avoid electronic component failures and ensure continued processing performance. It should also appreciated that the level of heat generated by the electronic processing equipment is correlated to processing demands that may fluctuate on an hourly, daily, or weekly basis.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source, *e.g.*, heat exchangers, dry coolers, *etc.*, via a liquid cooling circuit arrangement to circulate the cooling liquid throughout the equipment. As such, the liquid cooling blocks are positioned to be in direct thermal contact with the heat-generating components, so that the received cooling liquid absorbs the generated heat and the heated liquid is circulated, via the cooling circuit arrangement, back to cooling liquid source for re-cooling.

As noted above, the demand for processing resources fluctuates. As such, there remains an interest in improving the control of liquid cooling components and resources that take into account fluctuating demand to optimize operating efficiencies.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on the interest to improve the efficiency of conventional liquid cooling techniques and implementations. To this end, developers have addressed this issue by providing a solution that intelligently controls pump operations to dynamically adjust the cooling liquid pressure and flow rate based on certain events or periodically-assessed demand levels.

Therefore, one embodiment of the present technology is directed to a liquid cooling arrangement for providing a cooling liquid to datacenter rack-mounted server data processing assemblies, that contains a server branch comprising a server rack for housing the rack-mounted server processing assemblies and a smart control valve configured to control a flow of the cooling liquid supplied to the server rack; a liquid cooling subsystem comprising a pump unit configured to forcibly urge a flow of the cooling liquid from the liquid cooling subsystem to and from the server rack and an output pressure sensor configured to measure the pressure of the cooling liquid flow Po forcibly urged by the pump unit, the pump unit configured with a constant pressure operational mode setting that controls a speed of the pump unit to provide a cooling liquid pressure at a set constant pressure level; a liquid distribution circuit fluidly-coupled to the liquid cooling subsystem , the smart control valve , and the server rack , the liquid distribution circuit configured to convey the cooling liquid from the liquid cooling subsystem to the server rack and convey the heated liquid from the server rack back to the liquid cooling subsystem for recooling and recirculation therethrough; a feedback control system comprising a control unit and receiving a heat load level Q of the server rack for determining the constant pressure operational mode setting of the pump unit. The control unit is configured with executable instructions to: direct the pump unit to operate at full speed to provide a maximum pressure of cooling liquid flow; direct the smart control valve to open at maximum flow rate capacity; determine an optimal volume flow rate $m_{opt}$ based on the heat load level Q of the server rack and an empirical operational characteristic based on pump speeds and corresponding volume flow rates; determine a lowest efficient pump speed $PS_L$ that maintains the optimal cooling liquid flow rate $m_{opt}$; and set the constant pressure operational mode setting of the pump unit to operate in accordance with the determined lowest efficient pump speed $PS_L$. The the empirical pump operational characteristics define an efficient system operations curve relative to volume flow rates, pump speeds, and pump power consumption levels.

In a related aspect of the liquid cooling arrangement, the control unit is further configured to communicate with, and receive from, the pump unit and the smart control valve input and output cooling liquid temperatures levels *Ti, To* of the server rack (150-15L) to quantify the cooling liquid temperature difference $\Delta T$ and pump unit input and output pressure levels *Pi, Po* to quantify a pump pressure difference $\Delta P$ receive a cooling liquid temperature difference $\Delta T$ between input and output server rack cooling liquid temperatures, wherein the optimal volume flow rate $m_{opt}$ is further based on $\Delta T$ and $\Delta P$.

Another embodiment of the present technology is directed to a liquid cooling method for providing a cooling liquid to datacenter server data processing assemblies of a server rack that includes communicating with an input server rack temperature sensor, output server rack temperature sensor, input pump unit pressure sensor, output pump unit pressure sensor, and a smart control valve; directing the pump unit to operate at full capacity; directing the smart control valve to open at maximum flow rate capacity; quantifying a pressure difference $\Delta P$ between the input pressure sensor measurement and the output pressure sensor measurement; determining an optimal volume flow rate $m_{opt}$ based on a desired predetermined temperature difference $\Delta Td$ of X °K representing a desired temperature difference value between overall input and output temperatures and empirical pump operational characteristics regarding pump speeds and corresponding volume flow rates; determining a lowest efficient pump speed $PS_L$ that maintains the optimal cooling liquid flow rate $m_{opt}$; and setting the constant pressure operational mode setting of the pump unit to operate in accordance with the determined lowest efficient pump speed $PS_L$.

In a related aspect of the liquid cooling method, including a control unit communicating with the pump unit and issuing the steps for determining of the optimal volume flow rate $m_{opt}$, the lowest efficient pump speed $PS_L$, and setting the constant pressure operational mode setting of the pump unit. Additionally, the determining of the optimal volume flow rate $m_{opt}$ and the lowest efficient pump speed $PS_L$ is performed over one or more iterations and initiated based on detected cooling liquid flow rate changes or detected increased server rack temperatures.

The invention also relates to a computer program and computer-readable medium comprising instructions which, when the program is executed by a computer, cause the computer to carry out the steps of the method as previously described.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

Moreover, unless expressly provided otherwise, the words "first", "second", "third", etc. have been used as adjectives only for the purpose of allowing for distinction between the nouns that they modify from one another, and not for the purpose of describing any particular relationship between those nouns. It should also be understood that terms relating to the position and/or orientation of components such as "upper", "lower", "top", "bottom", "front", "rear", "left", "right", are used herein to simplify the description and are not intended to be limitative of the particular position/orientation of the components in use.

Furthermore, the use of the phrase "at least one of A and B" is intended to mean A only, B only, or both A and B.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

## BRIEF DESCRIPTION OF THE DRAWINGS

For a better understanding of the present technology, as well as other aspects and further features thereof, reference is made to the following description which is to be used in conjunction with the accompanying drawings, where:

FIG. 1A depicts a functional block diagram of a server cluster configuration of a datacenter server rack, in accordance with the non-limiting embodiments of the present disclosure;

FIG. 1B depicts a functional block diagram of a liquid cooling arrangement for servicing datacenter server racks, in accordance with the non-limiting embodiments of the present disclosure;

FIG. 2 depicts a functional block diagram of a liquid cooling arrangement for datacenter server racks directed to the control of a pump unit, in accordance with the non-limiting embodiments of the present disclosure;

FIG. 3 provides an exemplary graph depicting the functional relationship between pump unit pressure, cooling liquid flow rates, and pump power for efficient operations for the liquid cooling arrangement, in accordance with the non-limiting embodiments of the present disclosure;

FIG. 4 depicts a flow diagram of a process for periodically adjusting the control of the pump unit operations of the liquid cooling arrangement based on detected demand needs, in accordance with the nonlimiting embodiments of the present technology; and

FIG. 5 depicts a functional block diagram of a monitoring controller configured to execute processing control operations of the pump unit, in accordance with the nonlimiting embodiments of the present technology.

It is to be understood that, unless otherwise explicitly specified herein, the drawings are not necessarily rendered to scale. Moreover, the drawings may omit features or may exaggerate features in order to assist in the clear understanding of the disclosed embodiments.

## DETAILED DESCRIPTION

The instant disclosure is directed to addressing at least some of the issues associated with the conventional use of various piping conduit configurations and numerous pumps to supply the liquid flows to the liquid cooling blocks and to the air-to-liquid heat exchangers servicing the cooling needs of the multitude of heat-generating components.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any diagrams presented herein represent conceptual views of illustrative systems embodying the principles of the present technology.

As noted above, the heat levels generated by the electronic processing equipment is correlated to processing demands that tend to fluctuate on an hourly, daily, or even weekly basis. It will be appreciated that consistently operating a pump unit at the same speed and flow rate consumes a constant amount of energy even when the demand is low. This contributes to inefficient energy consumption, excessive wear and tear on the pump unit, and inadequate system response times to fluctuating demand.

With these fundamentals in place, the following disclosures are directed to providing the intelligent control of pump operations to dynamically adjust the cooling liquid pressure and flow rate based on certain events or periodically-assessed fluctuating demand levels in order to optimize overall system efficiency, in accordance with the inventive aspects and principles of the present disclosure.

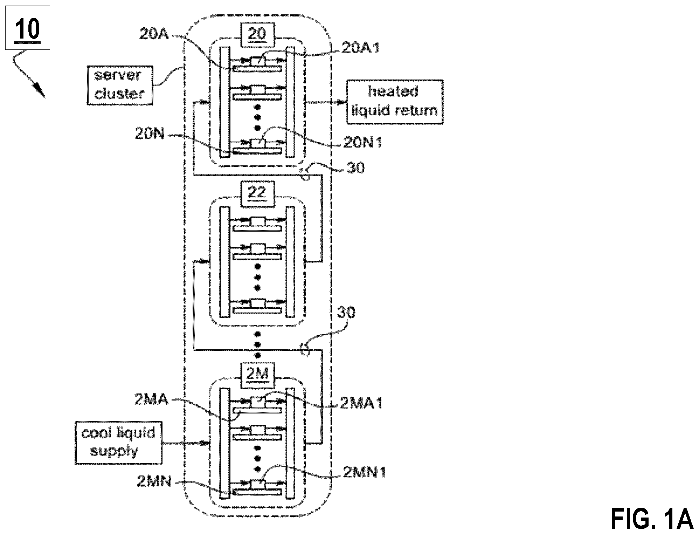

Accordingly, FIG. 1A depicts a functional block diagram of a representative internal server cluster **10** configuration of a datacenter server rack, in accordance with the non-limiting embodiments of the present disclosure. The representative server cluster **10** configuration comprises a plurality of server sub-clusters **20-2M,** in which each server sub-cluster **20-2M** correspondingly comprises a plurality of data processing assemblies **20A-20N** to **2MA-2MN** containing heat-generating electronic processing components. The heat-generating electronic components may comprise central processing units (CPUs), graphic processing units (GPUs), microcontroller units (MCUs), *etc.*

As shown, each of the data processing assemblies **20A-20N** to **2MA-2MN** incorporates at least one respective liquid cooling block unit (*i.e.*, water blocks) **20A1-20N1** to **2MA1-2MN1** disposed in direct thermal contact with the heat-generating electronic processing components. Each of the water blocks **20A1-20N1** to **2MA1-2MN1** is configured with internal conduits (*not shown*) to accommodate the circulated flow of channelized cooling liquid therethrough. The channelized cooling liquid is provided by a cooling liquid supply that is serially conveyed to each of the water blocks **20A1-20N1** to **2MA1-2MN1** via an internal server cluster liquid circulating channel 30 to absorb the thermal energy from the heat-generating electronic components and discharge the heated liquid therefrom.

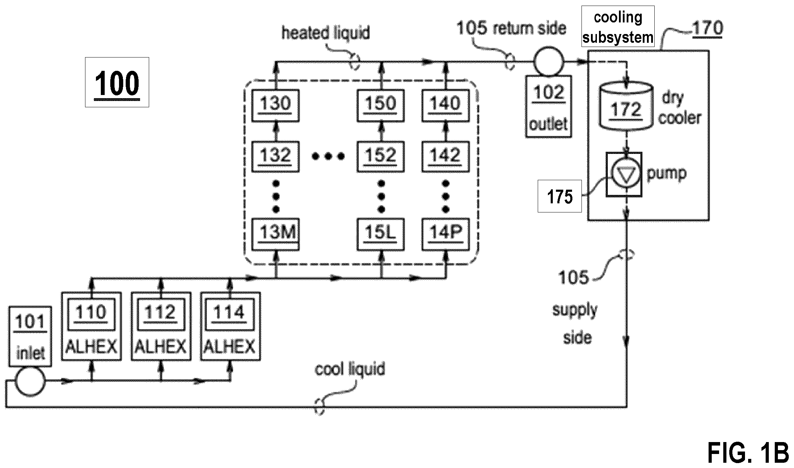

Given the internal datacenter server cluster **10** configuration described above, FIG. 1B depicts a functional block diagram of fluid cooling arrangement **100** for servicing the datacenter server racks, in accordance with the non-limiting embodiments of the present disclosure.

As shown, fluid cooling arrangement **100** comprises a single liquid distribution circuit 105 configured with a supply side for supplying a cooling liquid to the server clusters **130-13M, 140-14P, 150-15L** of a rack from a liquid cooling subsystem **170** and a return side for returning a heated liquid from the servers back to the liquid cooling subsystem **170** for recooling and recirculation back to the servers clusters **130-15L.** As noted above relative to FIG. 1A, each of the server clusters **130-15L** comprise data processing assemblies (*see*, *e.g.*, FIG. 1 **20A-20N** to **2MA-2MN)** that incorporate at least one corresponding water block **20A1-20N1** for direct thermal contact with the heat-generating electronic components for dissipation of heat therefrom.

Accordingly, FIG. 1B indicates that liquid distribution circuit **105** is configured with a liquid distribution inlet **101** along the "cool" supply side for supplying the cooling liquid to the fluidly-coupled server clusters **130-15L** and a liquid distribution outlet **102** along the "heated" return side for receiving a heated liquid from the server clusters **130-15L** and returning the heated liquid back to the liquid cooling subsystem **170** for recooling and recirculation back to the server clusters **130-15L.** The liquid distribution circuit **105** may be constructed from flexible materials (e.g., rubber, plastic, *etc.),* rigid materials (e.g., metal, PVC piping, *etc.),* or any combination of thereof. It will be appreciated that the conveyed cooling liquid may include water, alcohol, or any suitable liquid capable of sustaining adequate cooling temperatures. However, for the sake of consistency and understanding, the following disclosures will refer to the use of water as the cooling liquid or fluid.

As shown, the liquid cooling subsystem **170** comprises a dry cooler unit **172** configured to process and recondition the received heated water from the server racks to provide recooled water for recirculation back to the water blocks servicing the server clusters **130-15L** via the liquid distribution circuit **105.** The liquid cooling subsystem **170** further comprises a pump unit **175** configured to provide the necessary pressure and volume flow rate of the cooling water from the dry cooler unit **172** throughout the liquid distribution circuit **105.** The operational control of pump unit **175** will be described in further detail below.

The fluid cooling arrangement **100** further includes a plurality of air-to-liquid heat exchangers (ALHEXs) **110-114.** In the illustrated embodiment, the ALHEXs **110-114** are fluidly connected in parallel via the liquid cooling circuit **105** while also being fluidly coupled to the server clusters **130-15L** via the liquid cooling circuit **105.** It will be appreciated, however, that the ALHEXs **110-114** may be fluidly interconnected in other configurations, such as, for example, in series via the liquid cooling circuit **105** without departing from the concepts of the disclosed technology.

The ALHEXs **110-114** function to sufficiently cool the ambient air surrounding the server clusters **130-15L.** The ALHEXs **110-114** may embody any suitable configuration that reduces temperatures of supplied air flow (e.g. by compact fans), such as, internal cooling coils, heat extracting air flow fins, *etc.* The ALHEXs **110-114** may be, for example, disposed on rear doors of the rack hosting the server clusters **130-15L,** to directly cool the air exiting the server clusters **130-15L,** warmed by the air-cooled components therein.

The status of the cooling water temperature within the distribution circuit **105** during use is described as follows: water flow egresses out of the liquid cooling subsystem **170** and enters the distribution circuit **105** at a "cooling" temperature that is supplied to the water blocks **20A1-20N1** that thermally coupled to the heat-generating electronic components. The cooling water flow is internally-circulated through each of the data processing assemblies of the server clusters **130-15L** and standard priority server clusters **130-15L** for liquid cooling. As a result, the internally-circulated water becomes heated due to the heat-generating electronic components.

The "heated" water is then is supplied to the return side of the liquid distribution circuit **105** to be returned back to the liquid cooling subsystem **170** for recooling and recirculation back to all the server clusters **130-15L.** In certain implementations, the heated liquid temperature may range from approximately 45°C to 65°C, while the "cold" temperature is chosen approximately between 20°C to 40°C.

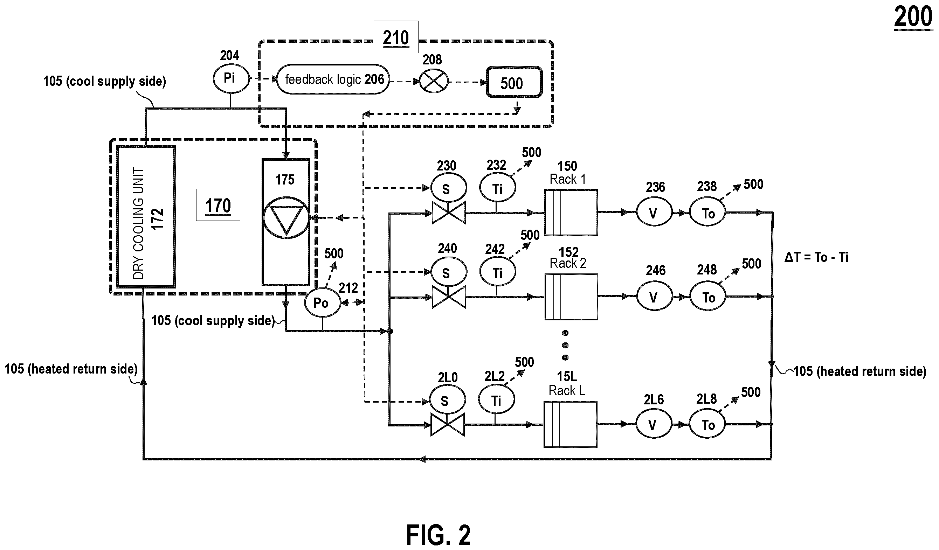

FIG. 2 depicts a functional block diagram of a liquid cooling arrangement **200** for datacenter server racks focusing on the dynamic control of pump unit **175** of the liquid cooling subsystem **170,** in accordance with the non-limiting embodiments of the present disclosure. In particular, FIG. 2 provides a comprehensive view of the liquid cooling arrangement **200** configuration and components designed to provide the intelligent control of pump unit **175** operations for dynamically adjusting the cooling liquid pressure and flow rate based on based on certain events or periodically-assessed demand levels in order to optimize overall system efficiency.

At a macro level, liquid cooling arrangement **200** incorporates the liquid cooling subsystem **170** comprising the dry cooling unit **172** and pump unit **175,** along with a feedback control system **210,** a series of branches containing server racks **150-15L,** and a liquid distribution circuit **105** to forward the cooling water to, and return heated water from, the server racks **150-15L.** The liquid cooling subsystem **170** operates to have dry cooling unit **172** supply cooling water to the pump unit **175** to force the flow of cooling water to the server racks **150-15L,** via liquid distribution circuit **105,** as well as return the water heated by the server racks **150-15L,** via liquid distribution circuit **105,** back to the dry cooling unit **172** for recooling of the heated water and recirculation.

The pump unit **175** is configured with a constant pressure operation setting mode that enables the pump to function under a set constant pressure level. The pump unit **175** may comprise a variable frequency driver (VFD) that, based on set parameters and detected demands, dynamically adjusts the the rotational frequency/speed (*in* rpms) of a pump impeller (*not shown*) that directly bears on the pump pressure *(in* kPa) and related volumetric cooling liquid flow rate capacity *(in* L/s). Accordingly, pump unit **175** is fluidly-coupled to the liquid distribution circuit **105** and configured to operate at a pump speed that forcibly urges the flow of the cooling liquid throughout the liquid distribution circuit **105** at adequate flow rates.

As shown in FIG. 2, input pressure sensor **204** measures the pressure ($Pi$) of the cooling liquid flow received by the pump unit **175** and output pressure sensor **212** measures the pressure ($Po$) of the cooling liquid flow forcibly outputted by pump unit **175**. The input and output pressure sensors **204**, **212** may be directly disposed on respective input and output ends of pump unit **175** or respectively immediately disposed upstream and downstream from pump unit **175.**

As also shown, each of the server rack **150-15L** branches respectively incorporate a "smart" valve **230-2L0** that may comprise an automatic balancing pressure control (ABQM) valve that is pressure-independent and temperature-responsive. ABQMs are configured to regulate their openings to maintain a consistent, stable cooling liquid flow, regardless of pressure fluctuations, in an autonomous manner. In some implementations ABQMs are also configured to communicate with a control unit that, based on control instructions, are capable of providing a further degree of overall system control.

Moreover, each of the server racks **150-15L** branches also incorporates an input temperature sensor **232-2L2** for measuring the temperature of the cooling liquid $Ti$ prior to the corresponding server racks **150-15L** and an output temperature sensor **238-2L8** for measuring the temperature of the cooling liquid $To$ after the corresponding server racks **150-15L.** The server racks **150-15L** then determine the temperature difference $\Delta T$ of the cooling liquid based on the $Ti$ and $To$ values.

Furthermore, control system **210** incorporates a feedback control loop comprising a control unit **500**, a feedback logic module **206**, and a comparator **208**. In certain nonlimiting embodiments, the control unit **500** may be integrated with, or part of, the pump unit **175** configuration. The feedback control system **210** operation may be activated upon initial system installation/commissioning as well as at predetermined scheduled intervals (*e.g.*, every 0.5 hr., 1 hr., 2 hrs, *etc.)* to provide periodically-updated pressure data based on observed and/or historical demand level variations throughout the day, week, holidays, season, *etc.*

The control unit **500** of feedback control system **210** is shown to be communicatively-coupled to the pump unit **175**, the input and output pressure sensors **204, 212.** In some embodiments, the control unit 500 is also communicatively-coupled to the smart valves **230-2L0.** In some embodiments, the control unit 500 is also communicatively-coupled to input/output temperature sensors **232-2L2, 238-2L8** of server rack **150-15L** branches. As will be described in greater detail below, the communicative arrangement between components of the server rack **150-15L** branches, allows feedback control loop of system **210** to dynamically control the pump unit **175** based on certain detected periodically-updated sensor levels, such as, for example, pressure differences $\Delta P$, temperature differences $\Delta T$, and a predetermined desired temperature difference $\Delta Td$ of X °K representing a desired temperature difference value between overall input and output temperatures to achieve an optimal cooling liquid flow rate $m_{opt.}$

It should be appreciated that the comprehensive architecture of liquid cooling arrangement **200** depicted by FIG. 2 allows for various operational applications to dynamically adjust the cooling liquid pressure to efficient levels. In one such operational application, the control unit **500** may only communicate with pump unit **175** and not have control communications to/from the components or sensors of the server rack **150-15L** branches.

For this operational application, the control unit **500** directs the pump unit **175** to operate fully at 100% speed to generate maximum pressure of cooling liquid flow. In some embodiments, the control unit **500** directs the smart valves **230-2L0** to fully open at 100% capacity or at a100% of the needed server rack flow.

The control unit **500** then determines an optimal volume flow rate ($m_{opt}$) based on the heat load level Q of the server rack **150-15L** and an empirical operational characteristic based on pump speeds and corresponding volume flow rates. In particular, the optimal flow rate $m_{opt}$ determination is conducted feedback logic module **206** which utilizes empirically-observed functional relationships between pump unit pressure (*in* kPa), cooling liquid volumetric flow rate (*in* L/s), pump power (*in* kW), and pump speed (*in* rpms) to identify the efficient pump operations given the measured prevailing conditions and/or desired threshold values.

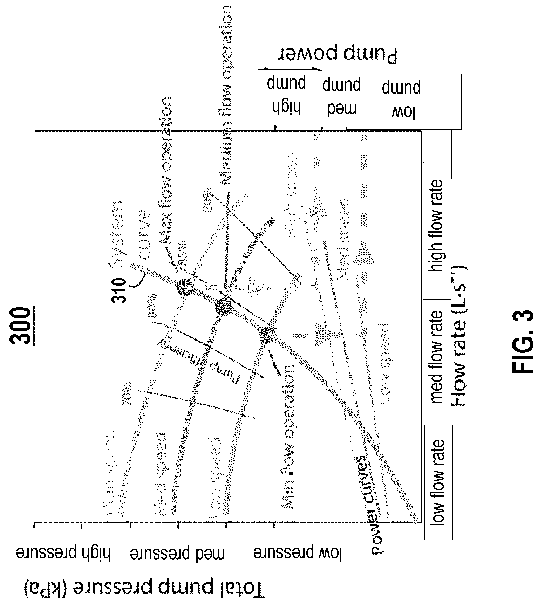

The empirical functional relationships between pump unit pressure, cooling liquid flow rate, pump power, and pump speed is represented by the exemplary pump characteristics graph **300** of FIG. 3, in accordance with the non-limiting embodiments of the present disclosure. As shown, graph **300** defines a system curve **310** that provides possible efficient volumetric flow rates $m_{opts}$ based on intersecting operating points with high, medium, and low pump speed characteristic curves. The intersecting points further indicate the corresponding high, medium, and low pump power consumption levels required to achieve the optimal flow rates $m_{opts.}$ It will be appreciated that, while most pump units generally exhibit the characteristic curves of graph **300**, pump specifications and operating parameter values may vary from model to model. For this reason, graph **300** does not include specific values and relies instead on providing ranges indicated by high, medium, and low levels.

The empirical pump-related relationships of graph **300** enable the feedback logic **206** of control system **210** to determine the optimal flow rate $m_{opt}$ from the possible flow rates $m_{opts}$ based on certain factors, such as, for example, heat load level Q, cooling liquid temperature difference $\Delta T$, pressure difference $\Delta P$, desired temperature difference $\Delta Td$ of X °K, *etc.* For instance, feedback logic **206** may determine the optimal flow rate $m_{opt}$ based on the updated temperature difference value $\Delta T$ and a desired temperature difference $\Delta Td$ (*e.g.*, 15°K, 20°K, 25°K, *etc.*). By way of background, the well known thermodynamic equation for determining a heat load Q is:

$$Q = m \bullet Cp \bullet \Delta T,$$

where:

m: represents the volumetric flow rate;
Cp: represents the specific heat; and
ΔT: represents the temperature difference.

Therefore, based on the known heat load Q, the specific heat Cp of the cooling liquid, and the desired temperature difference ΔTd, the optimal cooling liquid flow rate $m_{opt}$ can be determined by manipulating the equation to read as follows:

$$m_{opt} = Q / (Cp \bullet \Delta T)$$

Based on the manipulated equation, feedback logic module **206** is able to determine the pump speed necessary to identify the efficient cooling liquid flow rate $m_{opt}$ from the possible flow rates $m_{opts}$ of system curve **310**, in order to achieve the desired temperature difference ΔTd.

In turn, the control unit **500** directs pump unit **175** to reduce the pump speed to the lowest efficient level $PS_L$ that maintains the optimal cooling liquid flow rate $m_{opt}$ in order to optimize the efficiency of the power consumed by pump unit **175**. Accordingly, the constant pressure operation setting mode of pump unit **175** is set to operate at the determined lowest efficient pump speed $PS_L$. It will be appreciated that the determination of the optimal volume flow rate $m_{opt}$ and the lowest efficient pump speed $PS_L$ may be performed over one or more iterations.

In another operational application, the control unit **500** is configured to have control communications with each of the components or sensors of the server rack **150-15L** branches. That is, control unit **500** receives the updated input and output temperature levels Ti, To for each of the server rack **150-15L** branches to quantify the temperature difference ΔT by calculating the difference, via comparator **208**, between the updated input temperature levels Ti and the updated output temperature levels To. It will be appreciated that during the comparator stage, the smart valves **230-2L0** remain in a "frozen" state.

In turn, the control unit **500** directs pump unit **175** to fully operate at 100% capacity. The control unit **500** then receives the updated pump unit input and output pressure levels Pi, Po to quantify the pressure difference ΔP by calculating the difference between the updated input pump pressure level Pi and the updated output pump pressure level Po. In some embodiments, the control unit **500** directs the smart valves **230-2L0**, via control instructions, to fully open at 100% to minimize the pressure drop level of arrangement **200**.

Armed with the quantified updated pressure and temperature differences ΔP, ΔT, the feedback logic **206** of control system **210** determines the optimal flow rate $m_{opt}$ based on the updated pressure difference ΔP to have the temperature difference ΔT achieve and maintain the predetermined desired temperature difference ΔTd of X °K representing a desired temperature difference value between overall input and output temperatures. The control unit **500** then directs pump unit **175** to reduce the pump speed to the lowest efficient level $PS_L$ that maintains the optimal cooling liquid flow rate $m_{opt}$ in order to optimize the efficiency of the power consumed by pump unit **175**. Accordingly, the constant pressure operation setting mode of pump unit 175 is set to operate at the determined lowest efficient pump speed $PS_L$.

As noted above, the feedback control system 210 operation may be activated upon certain events, such as, initial system installation/commissioning, predetermined scheduled intervals (e.g., every 0.5 hr., 1 hr., 2 hrs, etc.) to provide periodically-updated pressure data based on observed and/or historical demand level variations throughout the day, week, holidays, season, etc. Moreover, the feedback control system 210 operation, the determination of the optimal volume flow rate $m_{opt}$ and/or the pump constant pressure operational mode setting may be initiated to increase/decrease in the event of detected substantial cooling liquid flow rate changes or increased due to detected increased temperatures of server racks **150-15L** resulting from increased processor demand levels.

In this manner, the configuration of liquid cooling arrangement **200** provides for the intelligent control of pump operations to dynamically adjust the cooling liquid flow rate in response to fluctuating demand levels in order to optimize pump efficiency and power consumption.

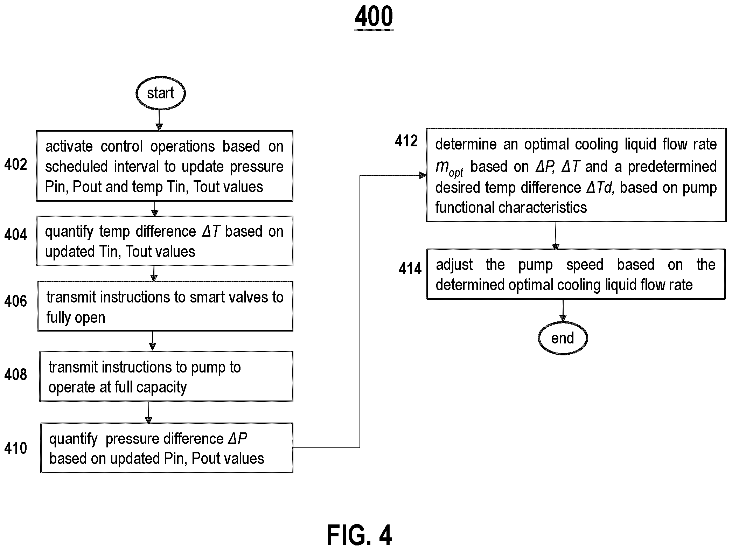

FIG. 4 depicts a flow diagram of process **400** for periodically adjusting the control of the pump unit operations of the liquid cooling arrangement based on detected demand levels, in accordance with the nonlimiting embodiments of the present technology.

Process **400** commences at task block **402**, in which control operations are activated to update input and output pressure levels Pi, Po and input and output temperature levels Ti, To. As noted above, control operations may be activated at predetermined scheduled intervals (e.g., every 0.5 hr., 1 hr., 2 hrs., etc.).

At task block **404**, control unit **500** quantifies the temperature difference ΔT by calculating the difference between the updated input temperature levels Ti and the updated output temperature levels To.

At task block **406**, control unit **500** may optionally direct the smart valves **230-2L0** to fully open at 100% to minimize the pressure drop level of arrangement **200**. At task block **408**, control unit **500** may direct pump unit **175** to fully operate at 100% capacity.

At task block **410**, control unit **500** quantifies the pressure difference ΔP by calculating the difference between the updated input pressure level *Pi* and the updated output temperature level *Po.*

At task block **412**, control system **210** determines an optimal cooling liquid flow rate $m_{opt}$ based on *ΔP*, *ΔT* and a predetermined desired temp difference *ΔTd,* based on the pump-related functional characteristics provided by graph **300**. That is, as noted above, the feedback logic **206** of control system **210** utilizes the functional characteristic relationships between the pump unit pressure, cooling liquid flow rate, pump power, and pump speed of graph **300** to: (a) determine possible optimal volumetric flow rates $m_{opt}$ along the system curve **310** of graph **300**; and (b) utilize the thermodynamic heat load Q equation to identify the optimal flow rate $m_{opt}$ that achieves the desired temperature difference *ΔTd* of X °K.

Finally, at task block **406**, control unit **500** directs the pump unit **175** to adjust (either increase or decrease) the pump speed to attain the optimal cooling liquid flow rate $m_{opt}$, which also directly bears on the power consumed by pump unit **175**.

In this manner, process **400** provides a method for the intelligent control of pump operations to dynamically adjust the cooling liquid flow rate in response to fluctuating demand levels in order to optimize pump efficiency and power consumption.

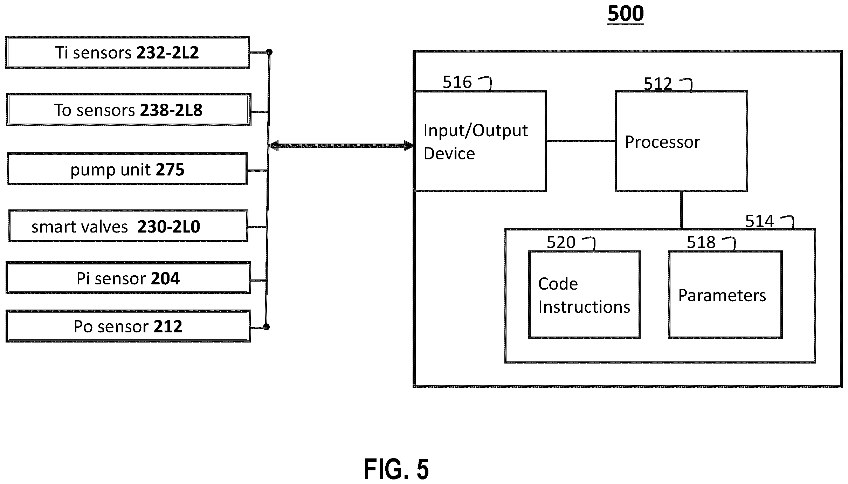

FIG. 5 illustrates a functional block diagram of controller **500** configured to execute the control processing operations noted above, in accordance with embodiments of the present technology.

As shown, controller **500** comprises a processor or a plurality of cooperating processors (represented as processor **512** for simplicity), a memory device or a plurality of memory devices (represented as memory device **514** for simplicity), one or more input devices and output devices, the input and output devices being possibly combined into one or more input/output devices (represented as a single input/output device **516** for simplicity). The processor **512** is operatively connected to the memory device **514** and to the input/output device **516**. The memory device is configured to store a list **518** of relevant parameters. The memory device **514** may comprise a non-transitory computer-readable media for storing control logic instructions **520** that are executable by the processor **512** and, in particular, the executing process **300** for optimally controlling the application of cooling water to the evaporating pad **150.**

As shown, processor 512 is communicatively coupled, via the input/output interface 516, to the one or more of the input temperature Ti sensors **232-2L2,** the output temperature To sensors **238-2L8,** the pump unit 275, the smart (*i.e.*, ABQM) valves **230-2L0,** the input temperature Pi sensor 204, and the output temperature Po sensor 204. The processor 512 is configured to execute the control logic instructions 520 stored in the memory device 514 to implement the various above-described functions of the controller 500.

While the above-described implementations have been described and shown with reference to particular steps performed in a particular order, it will be understood that these steps may be combined, subdivided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

**Claims**

**1.** A liquid cooling arrangement (200) for providing a cooling liquid to datacenter rack-mounted server data processing assemblies, comprising:

a server branch comprising a server rack (150-15L) for housing the rack-mounted server processing assemblies and a smart control valve (230-2L0) configured to control a flow of the cooling liquid supplied to the server rack (150-15L);

a liquid cooling subsystem (170) comprising a pump unit (175) configured to forcibly urge a flow of the cooling liquid from the liquid cooling subsystem (170) to and from the server rack (150-15L) and an output pressure sensor (212) configured to measure the pressure of the cooling liquid flow (Po) forcibly urged by the pump unit (175), the pump unit (175) configured with a constant pressure operational mode setting that controls a speed of the pump unit (175) to provide a cooling liquid pressure at a set constant pressure level;

a liquid distribution circuit (105) fluidly-coupled to the liquid cooling subsystem (170), the smart control valve (230-2L0), and the server rack (150-15L), the liquid distribution circuit (105) configured to convey the cooling liquid from the liquid cooling subsystem (170) to the server rack (150-15L) and convey the heated liquid from the server rack (150-15L) back to the liquid cooling subsystem (170) for recooling and recirculation therethrough;

a feedback control system (210) comprising a control unit (500) and receiving a heat load level Q of the server rack (150-15L) for determining the constant pressure operational mode setting of the pump unit (175), the control unit (500) configured with executable instructions to:

direct the pump unit (175) to operate at full speed to provide a maximum pressure of cooling liquid flow;

determine an optimal volume flow rate ($m_{opt}$) based on the heat load level Q of the server rack (150-15L) and an empirical operational characteristic based on pump speeds and corresponding volume flow rates;

determine a lowest efficient pump speed ($PS_L$) that maintains the optimal cooling liquid flow rate $m_{opt}$; and

set the constant pressure operational mode setting of the pump unit (175) to operate in accordance with the determined lowest efficient pump speed $PS_L$.

2. The liquid cooling arrangement (200) of claim 1, wherein the control unit (500) is further configured to receive a cooling liquid temperature difference $\Delta T$ between input and output server rack (150-15L) cooling liquid temperatures, wherein the optimal volume flow rate ($m_{opt}$) is further based on a desired predetermined temperature difference $\Delta Td$ of X °K of the cooling liquid.

3. The liquid cooling arrangement (200) of claims 1 or 2, wherein the empirical pump operational characteristics define an efficient system operations curve relative to volume flow rates, pump speeds, and pump power consumption levels.

4. The liquid cooling arrangement (200) of anyone of claims 1 to 3, wherein the determination of the optimal volume flow rate $m_{opt}$ and the lowest efficient pump speed $PS_L$ is performed over one or more iterations.

5. The liquid cooling arrangement (200) of anyone of claims 1 to 4, wherein the output pressure sensor (212) is disposed on an outlet side of the pump unit (175).

6. The liquid cooling arrangement (200) of anyone of claims 1 to 5, wherein the control unit (500) is further configured to communicate with, and receive from, input and output cooling liquid temperatures levels $Ti$, $To$ of the server rack (150-15L) to quantify the cooling liquid temperature difference $\Delta T$ and pump unit input and output pressure levels $Pi$, $Po$ to quantify a pump pressure difference $\Delta P$.

7. The liquid cooling arrangement (200) of claim 6, wherein the determination of the optimal volume flow rate $m_{opt}$ and/or the constant pressure operational mode setting of the pump unit (175) includes applying the pump pressure difference $\Delta P$ to the empirical operational characteristic.

8. The liquid cooling arrangement (200) of anyone of claims 1 to 7, wherein the control unit (500) is integrated with, or part of, the pump unit (175) configuration.

9. The liquid cooling arrangement (200) of anyone of claims 1 to 8, wherein the determination of the optimal volume flow rate $m_{opt}$ and the setting of the pump unit (175) constant pressure operational mode is initiated at periodic intervals.

10. The liquid cooling arrangement (200) of anyone of claims 1 to 9, wherein the setting of the pump unit (175) constant pressure operational mode is initiated based on detected cooling liquid flow rate changes.

11. The liquid cooling arrangement (200) of anyone of claims 1 to 9, wherein the setting of the pump unit (175) constant pressure operational mode is initiated based on detected increased server rack temperatures due resulting from processing demands.

12. The liquid cooling arrangement (200) of anyone of claims 1 to 9, wherein the control unit (500) is further configured with executable instructions to direct the smart control valve (230-2L0) to open at maximum flow rate capacity prior to determining the optimal volume flow rate ($m_{opt}$).

13. A liquid cooling method (400) for providing a cooling liquid to datacenter server data processing assemblies of a server rack (150-15L), comprising:

communicating with an input server rack temperature sensor (232-2L2), output server rack temperature sensor (238-2LN8), input pump unit pressure sensor (204), output pump unit pressure sensor (212), and a smart control valve (230-2L0);

directing the pump unit (175) to operate at full capacity;

quantifying a pressure difference ($\Delta P$) between the input pressure sensor (204) measurement and the output pressure sensor (212) measurement;

determining an optimal volume flow rate ($m_{opt}$) based on a desired predetermined temperature difference $\Delta Td$ of X °K representing a desired temperature difference value between overall input and output temperatures and empirical pump operational characteristics regarding pump speeds and corresponding volume flow rates;

determining a lowest efficient pump speed ($PS_L$) that maintains the optimal cooling liquid flow rate $m_{opt}$; and

setting the constant pressure operational mode setting of the pump unit (175) to operate in accordance with the determined lowest efficient pump speed $PS_L$.

14. The liquid cooling method (400) of claim 13, wherein the empirical pump operational characteristics define an efficient system operations curve relative to volume flow rates, pump speeds, and pump power consumption levels.

15. The liquid cooling method (400) of claims 13 or 14, wherein the determining of the optimal volume flow rate $m_{opt}$ and the lowest efficient pump speed $PS_L$ is performed over one or more iterations.

**Amended claims in accordance with Rule 137(2) EPC.**

1. A liquid cooling arrangement (200) for providing a cooling liquid to datacenter rack-mounted server data processing assemblies, comprising:

a server branch comprising a server rack (150-15L) for housing the rack-mounted server processing assemblies and a smart control valve (230-2L0) configured to control a flow of the cooling liquid supplied to the server rack (150-15L);
a liquid cooling subsystem (170) comprising:

a dry cooler unit (172) configured to supply the cooling liquid and receive heated water from the server rack (150-15L) to recool the heated water and recirculate the recooled water back to the server rack (150-15L);
a pump unit (175) configured to forcibly urge a flow of the cooling liquid from the dry cooler unit (172) to and from the server rack (150-15L), the pump unit (175) configured with a constant pressure operational mode setting that controls a speed of the pump unit (175) to provide a cooling liquid pressure at a set constant pressure level;
an output pressure sensor (212) configured to measure the pressure of the cooling liquid flow (Po) forcibly urged by the pump unit (175);

a liquid distribution circuit (105) fluidly-coupled to the liquid cooling subsystem (170), the smart control valve (230-2L0), and the server rack (150-15L), the liquid distribution circuit (105) configured to convey the cooling liquid from the liquid cooling subsystem (170) to the server rack (150-15L) and convey the heated liquid from the server rack (150-15L) back to the liquid cooling subsystem (170) for recooling and recirculation therethrough;
a feedback control system (210) comprising a control unit (500) and receiving a heat load level Q of the server rack (150-15L) for determining the constant pressure operational mode setting of the pump unit (175), the control unit (500) configured with executable instructions to:

direct the pump unit (175) to operate at full speed to provide a maximum pressure of cooling liquid flow;
determine an optimal volume flow rate ($m_{opt}$) based on the heat load level Q of the server rack (150-15L) and an empirical operational characteristic based on pump speeds and corresponding volume flow rates;
determine a lowest efficient pump speed ($PS_L$) that maintains the optimal cooling liquid flow rate $m_{opt}$; and
set the constant pressure operational mode setting of the pump unit (175) to operate in accordance with the determined lowest efficient pump speed $PS_L$.

2. The liquid cooling arrangement (200) of claim 1, wherein the control unit (500) is further configured to receive a cooling liquid temperature difference $\varDelta T$ between input and output server rack (150-15L) cooling liquid temperatures,
wherein the optimal volume flow rate ($m_{opt}$) is further based on a desired predetermined temperature difference $\varDelta Td$ of X °K of the cooling liquid.

3. The liquid cooling arrangement (200) of claims 1 or 2, wherein the empirical pump operational characteristics define an efficient system operations curve relative to volume flow rates, pump speeds, and pump power consumption levels.

4. The liquid cooling arrangement (200) of anyone of claims 1 to 3, wherein the determination of the optimal volume flow rate $m_{opt}$ and the lowest efficient pump speed $PS_L$ is performed over one or more iterations.

5. The liquid cooling arrangement (200) of anyone of claims 1 to 4, wherein the output pressure sensor (212) is disposed on an outlet side of the pump unit (175).

6. The liquid cooling arrangement (200) of anyone of claims 1 to 5, wherein the control unit (500) is further configured to communicate with, and receive from, input and output cooling liquid temperatures levels $Ti, To$ of the server rack (150-15L) to quantify the cooling liquid temperature difference $\varDelta T$ and pump unit input and output pressure levels $Pi, Po$ to quantify a pump pressure difference $\varDelta P$.

7. The liquid cooling arrangement (200) of claim 6, wherein the determination of the optimal volume flow rate $m_{opt}$ and/or the constant pressure operational mode setting of the pump unit (175) includes applying the pump pressure difference $\Delta P$ to the empirical operational characteristic.

8. The liquid cooling arrangement (200) of anyone of claims 1 to 7, wherein the control unit (500) is integrated with, or part of, the pump unit (175) configuration.

9. The liquid cooling arrangement (200) of anyone of claims 1 to 8, wherein the determination of the optimal volume flow rate $m_{opt}$ and the setting of the pump unit (175) constant pressure operational mode is initiated at periodic intervals.

10. The liquid cooling arrangement (200) of anyone of claims 1 to 9, wherein the setting of the pump unit (175) constant pressure operational mode is initiated based on detected cooling liquid flow rate changes.

11. The liquid cooling arrangement (200) of anyone of claims 1 to 9, wherein the setting of the pump unit (175) constant pressure operational mode is initiated based on detected increased server rack temperatures due resulting from processing demands.

12. The liquid cooling arrangement (200) of anyone of claims 1 to 9, wherein the control unit (500) is further configured with executable instructions to direct the smart control valve (230-2L0) to open at maximum flow rate capacity prior to determining the optimal volume flow rate ($m_{opt}$).

13. A liquid cooling method (400) for providing a cooling liquid to datacenter server data processing assemblies of a server rack (150-15L), the method utilizing a dry cooler unit (172) configured to supply the cooling liquid and a pump unit (175) configured to forcibly urge a flow of the cooling liquid from the dry cooler unit (172) to and from the server rack (150-15L), the method comprising:

   communicating with an input server rack temperature sensor (232-2L2), output server rack temperature sensor (238-2LN8), input pump unit pressure sensor (204), output pump unit pressure sensor (212), and a smart control valve (230-2L0);
   directing the pump unit (175) to operate at full capacity;
   quantifying a pressure difference ($\Delta P$) between the input pressure sensor (204) measurement and the output pressure sensor (212) measurement;
   determining an optimal volume flow rate ($m_{opt}$)

based on a desired predetermined temperature difference $\Delta Td$ of X °K representing a desired temperature difference value between overall input and output temperatures and empirical pump operational characteristics regarding pump speeds and corresponding volume flow rates;
   determining a lowest efficient pump speed ($PS_L$) that maintains the optimal cooling liquid flow rate $m_{opt}$; and
   setting the constant pressure operational mode setting of the pump unit (175) to operate in accordance with the determined lowest efficient pump speed $PS_L$.

14. The liquid cooling method (400) of claim 13, wherein the empirical pump operational characteristics define an efficient system operations curve relative to volume flow rates, pump speeds, and pump power consumption levels.

15. The liquid cooling method (400) of claims 13 or 14, wherein the determining of the optimal volume flow rate $m_{opt}$ and the lowest efficient pump speed $PS_L$ is performed over one or more iterations.

FIG. 1A

EP 4 766 050 A1

FIG. 1B

EP 4 766 050 A1

**FIG. 2**

EP 4 766 050 A1

## 300

**FIG. 3**

## 400

start

| 402 | activate control operations based on scheduled interval to update pressure Pin, Pout and temp Tin, Tout values |

| 404 | quantify temp difference $\Delta T$ based on updated Tin, Tout values |

| 406 | transmit instructions to smart valves to fully open |

| 408 | transmit instructions to pump to operate at full capacity |

| 410 | quantify pressure difference $\Delta P$ based on updated Pin, Pout values |

| 412 | determine an optimal cooling liquid flow rate $m_{opt}$ based on $\Delta P$, $\Delta T$ and a predetermined desired temp difference $\Delta Td$, based on pump functional characteristics |

| 414 | adjust the pump speed based on the determined optimal cooling liquid flow rate |

end

FIG. 4

EP 4 766 050 A1

**500**

Processor **512**

Input/Output Device **516**

**514**

Parameters **518**

Code Instructions **520**

Ti sensors **232-2L2**

To sensors **238-2L8**

pump unit **275**

smart valves **230-2L0**

Pi sensor **204**

Po sensor **212**

**FIG. 5**

| | Europäisches Patentamt European Patent Office Office européen des brevets | **EUROPEAN SEARCH REPORT** | **Application Number** EP 24 30 7252 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2011/060470 A1 (CAMPBELL LEVI A [US] ET AL) 10 March 2011 (2011-03-10) * paragraph [0033] - paragraph [0073]; figures 1-12 * | 1-15 | INV. H05K7/20 |
| A | US 2021/298191 A1 (SHAO SHUAI [US] ET AL) 23 September 2021 (2021-09-23) * paragraph [0026] - paragraph [0028]; figure 3 * | 1-15 | |
| A | US 2023/375279 A1 (KIM JOHN [US] ET AL) 23 November 2023 (2023-11-23) * paragraph [0265] - paragraph [0271]; figure 7 * | 1-15 | |

TECHNICAL FIELDS SEARCHED (IPC)

H05K

The present search report has been drawn up for all claims

| Place of search | Date of completion of the search | Examiner |
|---|---|---|
| The Hague | 6 June 2025 | Martinez Izquierdo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 7252

This annex lists the patent family members relating to the patent documents cited in  the above-mentioned European search report.
The members are as contained in the European Patent Office EDP file on
The European Patent Office is in no way liable for these particulars which are merely given for the purpose of information.

06-06-2025

| Patent document cited in search report | Publication date | Patent family member(s) | Publication date |
|---|---|---|---|
| US 2011060470 A1 | 10-03-2011 | NONE | |
| US 2021298191 A1 | 23-09-2021 | CN 113498300 A<br>US 2021298191 A1 | 12-10-2021<br>23-09-2021 |
| US 2023375279 A1 | 23-11-2023 | NONE | |

EPO FORM P0459

For more details about this annex : see Official Journal of the European Patent Office, No. 12/82